# EUROPEAN PATENT SPECIFICATION

(11) **EP 1 105 941 B1**
(45) Date of publication and mention of the grant of the patent: **15.03.2006**
(21) Application number: 99945040.6
(22) Date of filing: 11.08.1999
(51) Int. Cl.: H01R 12/20

(54) **CONNECTOR WITH TWO ROWS OF TERMINALS HAVING TAIL PORTIONS WITH SIMILAR IMPEDANCE**
VERBINDER MIT KONTAKTEN IN ZWEI REIHEN UND ENDSTÜCKEN MIT ÄHNLICHER IMPEDANZ
CONNECTEUR A DEUX RANGEES DE BROCHES A QUEUES D'IMPEDANCES SIMILAIRES

(30) Priority: 13.08.1998 JP 24257698
(43) Date of publication of application: 13.06.2001
(73) Proprietor: MOLEX INCORPORATED, Lisle Illinois 60532-1682 (US)
(72) Inventor: NODA, Atsuhito, Hachioji-shi, Tokyo (JP); HOSHINO, Tetsuo, Yokohama-shi, Kanagawa (JP); NIITSU, Toshihiro, Yokohama-shi, Kanagawa (JP); ASAKAWA, Tetsuya, Ha-12-406, Machida-Kiso Jutaku, Machida-shi, Tokyo 194-003 (JP)
(74) Representative: Davies, Gregory Mark
(86) International application number: PCT/US1999/018290
(87) International publication number: WO 2000/010228

(56) References cited:
- EP-A- 0 529 350
- DE-A- 3 412 700
- US-A- 4 628 410
- US-A- 5 256 085
- US-A- 5 281 169

## Description

The present invention relates to an electrical connector appropriate for use in transmitting high-frequency signals, and more particularly to a connector having terminals of substantially the same impedance.

In electronic applications that utilize high-frequency signals, it is desirable that the signal paths for such signals be optimized so as to control the resistance, capacitance and inductance which, in concert, affect the overall impedance of the signal paths. It is desirable to control the impedance of the signal path in order to prevent the degradation of the signals, especially high-frequency signals that traverse the signal path. Impedance may be easily controlled in electronic cables due to their construction, but it is more difficuft to control in connectors because of the arrangement and structure of the conductive terminals of the connector. The spacing of the terminals must be taken into account, as well as their shape and also the dielectric material used for the connector housing.

US 4628410 discloses connectors using two rows of terminals, however, the terminals do not have any intermediate portions that vary in length to control impedance thereof.

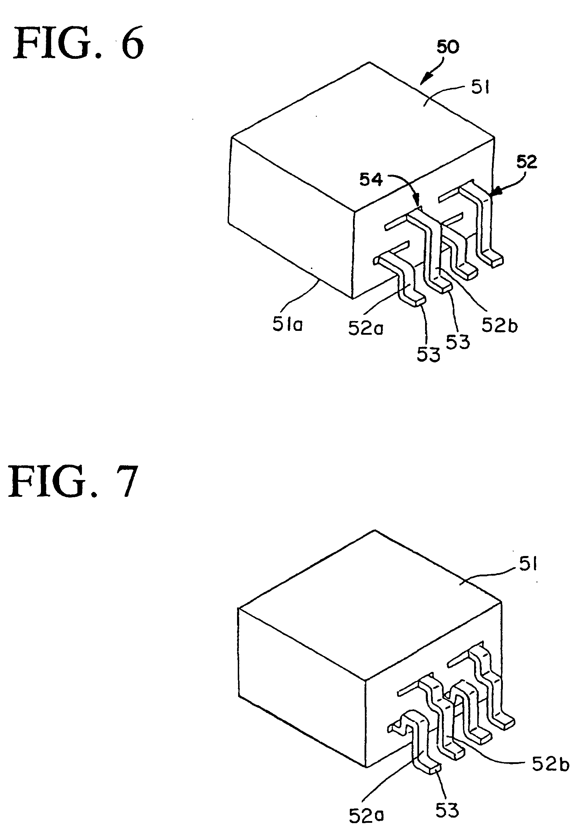

FIG. 6 illustrates a conventional electric connector 50 that has a plurality of terminals 54 mounted in an insulative housing 51. The terminals are arranged in two parallel rows (shown as upper and lower) that extend in the direction (lengthwise) in which an opposing connector is inserted. These terminals 54 have contact portions (not shown) that are disposed in the connector housing 51 and tail portions 52 that extend out of the connector into position for surface mount soldering to a circuit board. The tails 52 of these terminals have different tail sections 52a and 52b because the upper and lower terminals are bent so as to form "L"-shaped, vertical leg and horizontal foot extensions. The horizontal foot extensions 53 are arranged to be flush with the bottom 51a of the insulative housing 51, thus permitting the horizontal foot extensions 53 to be used as soldering tails so that the terminals 54 may be soldered to opposing pods or traces on the circuit board.

As seen in FIG. 6, the vertical tail sections 52a and 52b of the upper and lower terminals differ in their lengths. The difference in these two lengths also effects the "electrical" length of the upper and lower paired terminals and so cause an adverse effect on high-frequency signals traveling on a transmission path through this connector. This conventional structure promotes a drastic change in the impedance of the terminals where they exit the connector.

In order to lessen the difference of the impedance change, attempts have been made to make the tail sections 52a and 52b of the upper and lower terminals have the same length. As shown in FIG. 7, the tail sections 52a and 52b of the upper and lower terminals are formed to have the same length. However, because the tail sections 52a and 52b are arranged in two parallel rows in the connector housing 51, they must be bent at four different locations as shown to compensate for the different vertical distances from the lower and upper levels. This provides terminal tail sections of the same electrical length, as seen in FIG. 7. This is shown in Japanese Laid-Open Patent Application No. 6-60946.

Although the same length of the terminal tail sections, 52a, 52b of such connectors causes no adverse effect on the high-frequency signals transmitted therethrough, the work required to bend and form these terminals is complicated, and there exists difficulty in putting all of the terminal tail ends in a coplanar relation relative to the surface of the printed circuit board. This is due to an increased amount of springback in each tail section caused by the numerous bends that are complex or right-angle bends. This type of structure lowers the reliability with which the terminal tail ends can be soldered to selected conductors in a printed circuit board.

Accordingly, the present invention is directed to a connector having an improved terminal tail structure that overcomes the aforementioned disadvantages and provides improved electrical characteristics to the connector.

### Summary of the Invention

It is therefore a general object of the present invention to provide a connector in which terminal tail portions have the same length and which have a structure that facilitates their attachment to a circuit board.

Another object of the present invention is to provide a connector having two rows of terminals arranged in upper and lower rows in a connector housing, in which the terminals of the two rows have same electrical length, and are formed in a manner that facilitate the bending of the terminal tail sections.

Yet another object of the present invention is to provide a connector for surface mount applications with improved impedance characteristics wherein the connector includes a plurality of conductive terminals having contact portions disposed in the connector housing, tail portions exiting from the housing, the tail and contact portions being interconnected by respective intermediate portions, the terminal tail and intermediate portions of the two rows of terminals having substantially the same electrical length and being oriented in opposing directions.

Still yet another object of the present invention is to provide a connector with improved electrical impedance characteristics in which the connector has a connector housing that houses a plurality of terminals, the terminals being arranged in at least two horizontal discrete rows of terminals, with the terminals further being arranged in discrete pairs of terminals between the two rows of terminals so that each discrete terminal in one row of terminals is associated with another discrete terminal in the other row of terminals, the discrete terminals of the one row having intermediate portions that slope downwardly to their tail portions and the discrete terminals of the other row of terminals having intermediate portions that slope upwardly to their tail portions, the opposing sloping portions of both terminal rows meeting their respective tail portions along a common line so that the electrical length of the terminals in one row is substantially the same as the terminals in the other row, and wherein the terminal intermediate portions have widths hat vary along their length so as to achieve an impedance along the intermediate portions of discrete pairs of terminals that is substantially the same as that of the tail portions of the discrete pairs of terminals.

To attain these objects, a connector is provided in accordance with the present invention in which the tail sections of two rows of terminals exit from the rear face of the connector housing and the associated intermediate portions of the terminals being bent obliquely relative to the rear face of the connector housing. A plurality of conductive terminals are mounted in the connector housing of the connector. The terminals include discrete pairs of terminals are arranged at least two distinct rows, preferably in two upper and lower rows with one terminal in the upper row being associated with a specific terminal in the lower terminal row.

The terminals extend longitudinally out of the connector housing. The intermediate portions of the upper row of terminals are bent downward from the rear face of the connector housing to where they meet their associated tail portions, and the tail sections of the lower row of terminals are bent upward from the rear face of the connector housing. The intermediate portions of the terminals of the upper and lower row meet with their associated tail portions along a common line. This bending arrangement of the intermediate portions of the terminals places the solder tail portions in a coplanar relationship with the bottom face of the connector housing, thereby permitting the solder tail portions to be soldered to selected conductors on a circuit board.

The small number of bends is easy to accomplish and it also reduces the total amount of springback in each terminal tail section. The solder tail portions may be arranged to be flush with the bottom of the connector housing, thereby permitting required soldering to be performed on their surfaces. Alternatively, the solder tail portions may be vertical tails that can be inserted and soldered in selected through holes in a printed circuit board.

Each of the oblique, or sloping, portions of the terminal tail sections may have a width that preferably taper along their lengths toward their associated solder tail portions so that the surface area of the terminals is greater near the rear face of the connector housing which subsequently reduces along the length of the intermediate portions until they reach they associated tail portions. Thus, the upper and lower rows of terminals have a similar impedance as they exit out of the connector to thereby improve the transmitting performance for high-frequency signals.

These and other objects and advantages of the present invention will be clearly understood from the following detailed description.

### Brief Description of the Drawings

In the course of the following detailed description, reference will be made to the accompanying drawings in which:
FIG. 1 is a perspective view of the rear face of a connector constructed in accordance with the principles of one embodiment of the present invention;
FIG. 2 is an end view of the connector of FIG. 1;
FIG. 3 is a top plan view of the connector of FIG. 1;
FIG. 4 is an enlarged, partial top plan view of another embodiment of a connector constructed in accordance with the principles of the present invention;
FIG. 5 is an enlarged, partial top plan view of a third connector embodiment constructed in accordance with the principles of the present invention;
FIG. 6 is a perspective view taken from the rear of a conventional connector; and,
FIG. 7 is a perspective view taken from the rear of another conventional connector.

### Detailed Description of the Preferred Embodiments

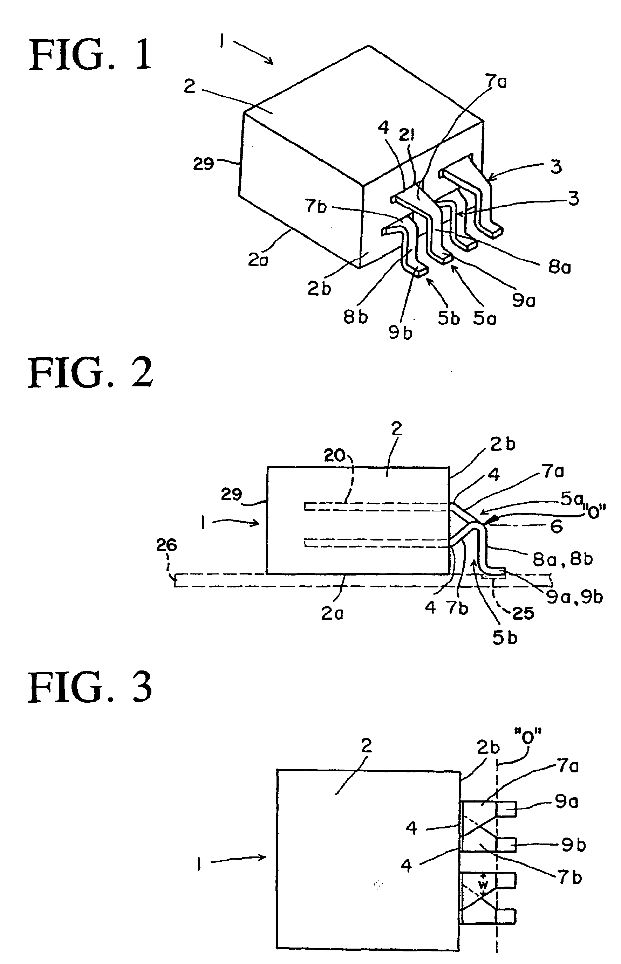

Referring now to FIGS. 1 to 3, a first embodiment of a connector 1 constructed in accordance with the principles of the present invention is illustrated as having a plurality of conductive terminals 3 mounted in an insulative connector housing 2. The connector 1 has a mating face 29 that is adapted to mate with an opposing connector (not shown). The terminals 3 are seen to be arranged in two generally parallel rows at upper and lower levels. These terminals extend longitudinally out from the connector housing 2 in the direction in which an opposing connector is inserted.

Each terminal 3 may be made by stamping it from a thin metal sheet with dies. Each terminal has a male or female contact portion 20 (shown in phantom in FIG. 2) formed at one end, an intermediate retaining portion 4 consecutive to the male or female contact portion 20, and a tail portion 5a, 5b formed at the other end, and also consecutive to the intermediate retaining section 4. When the terminal 3 is inserted in a selected terminal slot 21 formed in the rear side 2b of the connector housing 2, the terminal 3 is secured in the rear wall 2b of the connector housing 2 by the intermediate retaining portion 4, thereby allowing the male or female contact portion to project lengthwise in the connector housing 2. At the same time, the tail portion 5a or 5b extends rearwardly from the rear face 2b of the connector housing 2 (shown to the right in FIGS. 2 and 3).

As seen in FIGS. 2 and 3, the intermediate portions 7a of the upper row of terminals also project from the rear face 2b of the connector housing 2 and are bent at an angle (obliquely, with respect to the rear face 2b of the connector housing 2) downwardly to where they join their associated tail portions 5a. Similarly, the intermediate portions 7b of the lower row of terminals are bent at an angle upwardly to join their associated tail portions 5b. As seen best in FIG. 2, the two planes in which the intermediate portions of the upper and lower terminals lie intersect each other at point "O" that is shown generally at 6 in FIG. 3. This point O may also be considered as a common line that extends transversely to the terminals 3 and separates the intermediate portions 7a, 7b from their associated vertical leg portions 8a, 8b.

The tail portions 5a of the upper terminal row are generally L-shaped with vertical legs 8a and horizontal feet 9a. The tail portions 5b of the lower terminal now are also generally L-shaped with associated legs 8b and horizontal feet 9b. The mounting feet 9a, 9b preferably lie in the same plane and are also preferably generally flush with, or slightly beneath the bottom face 2a of the connector housing 2, to thereby act as solder tails for attachment to opposing conductive pads 25 on a circuit board 26, shown in phantom.

As mentioned above, the upper and lower terminals 3 are paired together vertically for use, and each pair of terminals has same characteristic impedance as the other pair of terminals. With this pairing, a single terminal 5a of the upper row of terminals is associated with a single terminal 5b of the lower row of terminals. Thus, this pair of terminals may be connected to a differential pair of another electronic component or device by way of an opposing connector (not shown). As seen best in FIGS. 1 and 3, the terminals of each such pair are offset from each other in the horizontal direction. As seen in the embodiment of FIG. 3, the oblique, or sloping, extensions 7a and 7b have a width "W" that tapers, or reduces down in a gradual manner to the width of the tail portions 5a, 5b that occur at the point where the intermediate portions join with the tail portions, shown at 6 in FIG. 2. The characteristic impedance of the paired terminals varies proportionally to the terminal-to-terminal distance, and inversely proportionally to the confronting terminal area.

It can thus be seen that the intermediate and tail portions of each terminal 3 are bent at three different places, and one of the angles is an obtuse angle. Thus, the required bending work is not especially complex compared to the terminals shown in FIG. 7. Moreover, the small number of bends reduces the amount of springback as compared to the known terminal structures of FIG. 7. Springback, as used herein, is the inherent property of most metals that occurs when a metal shape is being bent. The material has a tendency to "spring back" toward its original shape. The more bends that are present in a terminal such as the prior art terminal shown in FIG. 7, the greater the difficulty in controlling the tolerances (i.e., the location of the flat tail portions 9a, 9b) because each bend has springback associated therewith. The reduced springback of the connectors of the present invention increases the likelihood that he solder tails 9a and 9b will lie flush with the bottom face 2a of the connector 2, thus permitting the soldering tails 9a and 9b to be put exactly on selected conductors 25 of the circuit board 26. Thus, the required soldering can be effected with an increased reliability.

Each pair of terminals has substantially the same characteristic impedance, and therefore, a transmission line using the connectors of the invention will be free of reflection and loss of high-frequency signals traveling along the transmission line. The connectors of the invention are thus most appropriate to use with differential pairs of wires or other differential conductors. For any given differential pair, one conductor of the pair will carry current flow in one direction while the other conductor of the pair will carry an equal current flow in the opposite direction. The current flows in each of these wires will generate its own electromagnetic field, whose orientation is dependent on the flow of current through the conductor. These differential pairs are contained in a cable and in the opposing connector that mates with the connector of FIGS. 1-3 at its front face 1.

Current will flow in the connector terminals 5a, 5b in the same direction as it flows in the associated differential pairs of the opposing mating connector. For example, the left terminal of the top row may have a voltage out or positive terminal while its associated lower row terminal would be a voltage return or negative terminal. In any event, each terminal will generate an electrical field. These fields oppose each other and will have a canceling effect on the other to substantially suppress radiated emissions from the terminals. The line along which this canceling occurs is considered a "virtual" ground because the potential of the electric fields are zero at that point.

The angles of the intermediate sections assist in both reducing the springback of the tail portions and keeping the terminals the same length. Because the tail portions of the terminals are also of the same length, the pairs of terminals 5a and 5b have the same electrical length. This assists in maintaining the pairs of terminals at the same impedance. The tapering width of the terminal intermediate portion also assists in this function. The terminal intermediate portions 7a, 7b are wider near the rear face of the connector housing and become narrower gradually (depicted as a linear reduction in FIG. 3) until they match the width of the tail portions 8a-b and 9a-b. As they taper in their widths, the distance between them is reduced until at the point O at 6 in FIG. 2, the taper is eliminated and the intermediate portions join the vertical leg portions 8a, 8b such that all of the terminals of the connector are now in side-by-side order.

The effect of this terminal structure, including the gradual tapering, is that the impedance of the terminals is maintained to the point O. This is due in part to the large width, and hence, greater surface area of the two terminal intermediate portions 7a, 7b near the rear face of the connectors that increases the capacitance of the pairs of terminals at the rear face of the connector 2. This capacitance decreases as the spacing between the terminal intermediate portions 7a, 7b (and the widths thereof) decreases to a level at point **O** where the terminal intermediate portions join the vertical legs 8a, 8b of the terminals. At this point the legs 8a, 8b and the feet 9a, 9b are arranged in a closer spacing in a side-by-side order. Thus, by tapering or flaring the width of the terminals along the intermediate portions 7a, 7b of the terminals 5a, 5b while bringing them toward each other at an angle to point **O**, the characteristic impedance of the terminals will likely be maintained at substantially the same levels.

The connector described above has its solder tails 9a and 9b flush with the bottom 2a of the connector housing 2, thereby permitting the solder tails 9a and 9b to be soldered on selected conductors in a printed circuit board. Alternatively, the solder tails may use vertical, throughhole pins in place of the L-shaped leg-and-foot extension, thereby permitting the solder tails to be inserted in througholes in the circuit board for soldering. In this modification, each tail section is bent only at two selected places, thereby further reducing the needed bending.

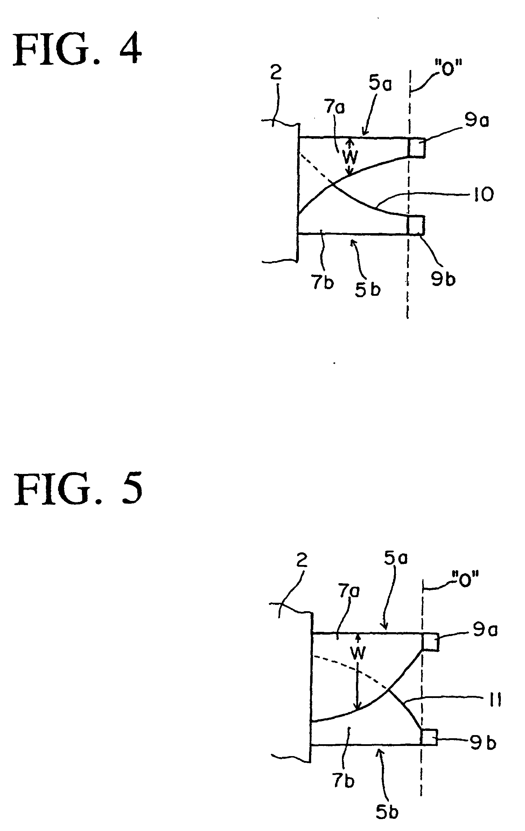

The tapering of the tail intermediate portions need not be limited to the linear taper shown in FIG. 3. FIG. 4 illustrates another embodiment wherein the tapering is more of a "flared" configuration along at least one arcuate or curvilinear path, shown at 10 as extending in a concave manner inwardly. Likewise, FIG. 5 shows another embodiment where in the flaring occurs in an convex or outward manner along reference number 11.

## Claims

1. A connector (1) having improved impedance characteristics, comprising:
a connector housing (2) formed from a dielectric material, the connector housing (2) having a mating face (29) and a mounting face (2b) separated by an intervening body portion; a plurality of conductive terminals (3) disposed in the connector housing (2), said terminals (3) being arranged in at least two discrete rows of terminals, the two discrete rows of terminals being spaced apart from each other a predetermined distance, each of said at least two discrete rows of terminals having the same number of terminals to define associate pairs of terminals, one terminal of said pair being present in one of said at least two discrete rows and the other terminal of said pair being present in the other of said at least two discrete rows;
each of the terminals (3) including a contact portion (20) and a tail portion (5a, 5b), the contact portion (20) being disposed within said connector housing (2), the tail portion exiting from said connector housing (2), said tail portion including a solder tail portion[s] (9a, 9b) [that is] adapted for connection to a printed circuit board (26), and each said tail portion (5a,5b), further including an intermediate tail portion (7a, 7b) interposed between said contact portion (20) and said solder tail portion (9a,9b) and joining said contact portion (20) and said solder tail portion (9a,9b) together outside of said connector housing (2);
said intermediate tail portions (7a) of said terminals of said one of said at least two discrete terminal rows extending from said connector housing mounting face (2b)/and toward said solder tail portions (9a) in a first plane which extends obliquely downwards relative to said mounting face, and said intermediate tail portions (7b) of said terminals of said other of said at least two discrete terminal rows extending from said connector housing mounting face (2b) / and towards said solder tail portions (96) in a second plane which extends obliquely upwards relative to said mounting face, said first and second planes intersecting each other along a line (O) positioned at a junction between the inclined intermediate tail portions (7a,7b) and the solder tail portions (9a,9b) of both of said rows of terminals such that the overall electrical length of said at least two discrete rows of terminal tail portions (5a, 5b) is substantially the same.

2. The connector as defined in claim 1, wherein said first and second rows of terminals exit from said connector housing mounting face (2b) in respective upper and lower terminal rows.

3. The connector as defined in claim 1 or 2, wherein said intermediate portions (7a, 7b) of said terminals of each of said at least two discrete terminal rows have a width that varies from said connector housing rear face (2b) to said remainder sections of said terminal tail portions (5a, 5b).

4. The connector as defined in claim 3, wherein said intermediate portions (7a, 7b) of each of said at least two discrete rows of terminals are tapered rearwardly along their length.

5. The connector as defined in claim 3, wherein said intermediate portions (7a, 7b) of each of said at least two discrete rows of terminals are flared rearwardly along their length.

6. The connector as defined in claim 3, wherein said intermediate portions (7a, 7b) of said terminals (3) ofeach ofsaid at least two discrete terminal rows have a surface area that varies along their length, the surface area of said intermediate portions (7a, 7b) being greater proximate to said connector housing mounting face (2b) and being lesser proximate to said remainder sections of said tail portions (5a, 5b).

7. The connector as defined in claim 4, wherein said intermediate portions (7a, 7b) of said first and second terminal rows are tapered linearly along their length.

8. The connector as defined in claim 5, wherein said intermediate portions (7a, 7b) of said first and second terminal rows arc arcuately flared along their length.

9. The connector as defined in claim 8, wherein said arcuate flare is concave.

10. The connector as defined in claim 8, wherein said arcuate flare is convex.

11. The connector as defined in any preceding claim, wherein each of said terminal solder tail portions (9a, 9b) includes a mounting foot, and all of the mounting feet of said terminal solder tail portions are arranged approximately flush with abottom surface of said connector housing (2).

12. The connector as defined in any preceding claim, wherein said terminals in said upper terminal row are offset with respect to said terminals in said lower row.

13. The connector as defined in claim 1, wherein each of said terminal intermediate portions (7a, 7b) has a predetermined length extending between said connector housing mounting face (2b) and said remainder sections of the associated terminal tail portion (5a, 5b), each or said terminal intermediate portions (7a, 7b) has a width that varies along its length, the width of said intermediate portions (7a, 7b) being approximately the same as a width of said remainder sections of said tail portions (5a, 5b) and increasing as the intermediate portions (7a, 7b) approach said connector mounting face (2b).

14. The connector as defined in claim 13, wherein said first and second rows of terminals exit from said connector housing mounting face (2b) in respective upper and lower terminal rows and terminals in said upper row are offset with respect to terminals in said lower row.

15. The connector as defined in any preceding claim, wherein each of said terminal tail portions (5a, 5b) includes a vertical leg portion that is joined to the associated said intermediate portion (7a, 7b).

## Revendications

1. Connecteur (1) présentant des caractéristiques d'impédance améliorées, comprenant :
un boîtier de connecteur (2) réalisé en un matériau diélectrique, le boîtier de connecteur (2) comportant une face d'accouplement (29) et une face de montage (2b) séparées par une partie de corps intermédiaire ; une pluralité de bornes (3) conductrices disposées dans le boîtier de connecteur (2), lesdites bornes (3) étant agencées en au moins deux rangées discrètes de bornes, les deux rangées discrètes de bornes étant espacées l'une de l'autre d'une distance prédéterminée, chacune desdites au moins deux rangées discrètes de bornes comportant le même nombre de bornes afin de définir des paires associées de bornes, une borne de ladite paire étant présente dans la première desdites au moins deux rangées discrètes et l'autre borne de ladite paire étant présente dans la seonde desdites au moins deux rangées discrètes ;
chacune des bornes (3) comprenant une partie de contact (20) et une partie de queue (5a, 5b), la partie de contact (20) étant disposée dans ledit boîtier de connecteur (2), la partie de queue sortant dudit boîtier de connecteur (2), ladite partie de queue comprenant une/des parties de queue de soudage (9a, 9b) adaptées pour une connexion à une carte de circuit imprimé (26) et chacune desdites parties de queue (5a, 5b) comprenant en outre une partie de queue intermédiaire (7a, 7b) interposée entre ladite partie de contact (20) et ladite partie de queue de soudage (9a, 9b) et reliant ladite partie de contact (20) et ladite partie de queue de soudage (9a, 9b) l'une à l'autre à l'extérieur dudit boîtier de connecteur (2) ;
lesdites parties de queue intermédiaires (7a) desdites bornes de ladite première desdites au moins deux rangées discrètes de bornes s'étendant à partir ladite face de montage (2b) de boîtier de connecteur et vers lesdites parties de queue de soudage (9a) dans un premier plan qui s'étend obliquement vers le bas par rapport à ladite face de montage, et lesdites parties de queue intermédiaires (7b) desdites bornes de ladite seconde desdites au moins deux rangées discrètes de bornes s'étendant à partir de ladite face de montage (2b) de boîtier de connecteur et vers lesdites parties de queue de soudage (9b) dans un deuxième plan qui s'étend obliquement vers le haut par rapport à ladite face de montage, lesdits premier et deuxième plans se croisant l'un l'autre le long d'une ligne (O) positionnée au niveau d'une jonction entre les parties de queue intermédiaires (7a, 7b) inclinées et les parties de queue de soudage (9a, 9b) desdites deux rangées de bornes de sorte que la longueur électrique entière desdites au moins deux rangées discrètes de parties de queue (5a, 5b) de bornes soit sensiblement la même.

2. Connecteur selon la revendication 1, dans lequel lesdites première et deuxième rangées de bornes sortent de ladite face de montage (2b) de boîtier de connecteur en rangées de bornes supérieure et inférieure respectives.

3. Connecteur selon la revendication 1 ou 2, dans lequel lesdites parties intermédiaires (7a, 7b) desdites bornes de chacune desdites au moins deux rangées discrètes de bornes ont une largeur qui varie de ladite face arrière (2b) de boîtier de connecteur vers lesdites sections restantes desdites parties de queue (5a, 5b) de borne.

4. Connecteur selon la revendication 3, dans lequel lesdites parties intermédiaires (7a, 7b) de chacune desdites au moins deux rangées discrètes de bornes sont effilées vers l'arrière le long de leur longueur.

5. Connecteur selon la revendication 3, dans lequel lesdites parties intermédiaires (7a, 7b) de chacune desdites au moins deux rangées discrètes de bornes sont évasées vers l'arrière le long de leur longueur.

6. Connecteur selon la revendication 3, dans lequel lesdites parties intermédiaires (7a, 7b) desdites bornes (3) de chacune desdites au moins deux rangées discrètes de bornes ont une aire de surface qui varie le long de leur longueur, l'aire de surface desdites parties intermédiaires (7a, 7b) étant plus grande à proximité de ladite partie de montage (2b) de boîtier de connecteur et étant plus petite à proximité desdites sections restantes desdites parties de queue (5a, 5b).

7. Connecteur selon la revendication 4, dans lequel lesdites parties intermédiaires (7a, 7b) desdites première et deuxième rangées de bornes sont effilées linéairement le long de leur longueur.

8. Connecteur selon la revendication 5, dans lequel lesdites parties intermédiaires (7a, 7b) desdites première et deuxième rangées de bornes sont évasées en forme d'arc le long de leur longueur.

9. Connecteur selon la revendication 8, dans lequel ledit évasement en forme d'arc est concave.

10. Connecteur selon la revendication 8, dans lequel ledit évasement en forme d'arc est convexe.

11. Connecteur selon l'une quelconque des revendications précédentes, dans lequel chacune desdites parties de queue de soudage (9a, 9b) de borne comprend un pied de montage, et tous les pieds de montage desdites parties de queue de soudage de borne sont agencés à peu près à niveau avec une surface inférieure dudit boîtier de connecteur (2).

12. Connecteur selon l'une quelconque des revendications précédentes, dans lequel lesdites bornes dans ladite rangée de bornes supérieure sont décalées par rapport auxdites bornes dans ladite rangée inférieure.

13. Connecteur selon la revendication 1, dans lequel chacune desdites parties intermédiaires (7a, 7b) de borne a une longueur prédéterminée s'étendant entre ladite face de montage (2b) de boîtier de connecteur et lesdites sections restantes de la partie de queue (5a, 5b) de borne associée, chacune desdites parties intermédiaires (7a, 7b) de borne a une largeur qui varie le long de sa longueur, la largeur desdites parties intermédiaires (7a, 7b) étant à peu près identique à une largeur desdites sections restantes desdites parties de queue (5a, 5b) et augmentant alors que les parties intermédiaires (7a, 7b) s'approchent de ladite face de montage (2b) de connecteur.

14. Connecteur selon la revendication 13, dans lequel lesdites première et deuxième rangées de bornes sortent de ladite face de montage (2b) de boîtier de connecteur dans les rangées de bornes supérieure et inférieure respectives et les bornes dans ladite rangée supérieure sont décalées par rapport aux bornes dans ladite rangée inférieure.

15. Connecteur selon l'une quelconque des revendications précédentes, dans lequel chacune desdites parties de queue (5a, 5b) de borne comprend une partie de patte verticale qui est reliée à ladite partie intermédiaire (7a, 7b) associée.

## Patentansprüche

1. Verbinder (1) mit einer verbesserten Impedanzcharakteristik, der aufweist:
ein Verbindergehäuse (2), das aus einem dielektrischen Material gebildet ist, welches Verbindergehäuse (2) eine Zusammenfügungsfläche (29) und eine Montagefläche (2b) aufweist, die durch einen dazwischen angeordneten Körperteil getrennt sind; eine Mehrzahl von leitenden Anschlüssen (3), die im Verbindergehäuse (2) angeordnet sind, welche Anschlüsse (3) in wenigstens zwei getrennten Reihen von Anschlüssen angeordnet sind, wobei die beiden getrennten Reihen von Anschlüssen voneinander um einen vorbestimmten Abstand beabstandet sind,
wobei jede der wenigstens zwei getrennten Reihen von Anschlüssen dieselbe Anzahl von Anschlüssen habt, um verknüpfte Paare von Anschlüssen zu definieren, wobei ein Anschluss des Paars in einer der wenigstens zwei getrennten Reihen vorhanden ist und der andere Anschluss des Paars in der anderen der wenigstens zwei getrennten Reihen angeordnet ist;
wobei jeder Anschluss (3) einen Kontaktteil (20) und einen Schwanzteil (5a, 5b) einschließt, wobei der Kontaktteil (20) innerhalb des verbindergehäuses (2) angeordnet ist, der Schwanzteil aus dem verbindergehäuse (2) herausragt, wobei der Schwanzteil einen Lötschwanzteil (9a, 9b) einschließt, der für Verbindung mit einer gedruckten Schaltungsplatine (26) ausgebildet ist und jeder Schwanzteil (5a, 5b) weiter einen dazwischen angeordneten Schwanzteil (7a, 7b) einschließt, der zwischen dem Kontaktteil (20) und dem Lötschwanzteil (9a, 9b) angeordnet ist und den Kontaktteil (20) und den Lötschwanzteil (9a, 9b) miteinander außerhalb des Verbindergehäuses (2) verbindet;
wobei sich die dazwischen angeordneten schwanzteile (7a) der Anschlüsse der einen der wenigstens zwei getrennten Anschlussreihen von der verbindergehäusemontagefläche (2b) und zu den Lötschwanzteilen (9a) in einer ersten Ebene erstrecken, die sich schräg nach unten relativ zur Montagefläche erstreckt und die dazwischen angeordneten Schwanzteile (7b) der Anschlüsse der anderen der wenigstens zwei getrennten Anschlussreihen sich von der Verbindergehäusemontagefläche (2b) und zu den Lötschwanzteilen (9b) in einer zweiten Ebene erstrecken, die sich schräg nach oben relativ zur Montagefläche erstreckt, wobei sich die ersten und zweiten Ebenen entlang einer Linie (O) schneiden, die an einer Verbindungsstelle zwischen den geneigten dazwischen angeordneten Schwanzteilen (7a, 7b) und den Lötschwanzteilen (9a, 9b) beider Reihen von Anschlüssen positioniert ist, so dass die elektrische Gesamtlänge der wenigstens zwei getrennten Reihen von An-Schlussschwanzteilen (5a, 5b) im wesentlichen dieselbe ist.

2. Verbinder nach Anspruch 1, bei dem die ersten und zweiten Reihen von Anschlüssen aus der Verbindergehäusemontagefläche (2b) in oberen und unteren Anschlussreihen heraustreten.

3. Verbinder nach Anspruch 1 oder 2, bei dem die dazwischen angeordneten Teile (7a, 7b) der Anschlüsse jeder der wenigstens zwei getrennten Anschlussreihen eine Breite haben, die sich von der Verbindergehäuserückfläche (2b) zu den restlichen Abschnitten der Anschlussschwanzteile (5a, 5b) verändert.

4. Verbinder nach Anspruch 3, bei dem die dazwischen angeordneten Teile (7a, 7b) jeder der wenigstens zwei getrennten Reihen von Anschlüssen sich nach rückwärts entlang ihrer Länge verjüngen.

5. Verbinder nach Anspruch 3, bei dem die dazwischen angeordneten Teile (7a, 7b) jeder der wenigstens zwei getrennten Reihen von Anschlüssen sich nach hinten entlang ihrer Länge erweitern.

6. Verbinder nach Anspruch 3, bei dem die dazwischen angeordneten Teile (7a, 7b) der Anschlüsse (3) jeder der wenigstens zwei getrennten Anschlussreihen ein Oberflächengebiet haben, das sich entlang ihrer Länge ändert, wobei das Oberflächengebiet der dazwischen angeordneten Teile (7a, 7b) größer ist nahe bei der Verbindergehäusemontagefläche (2b) und kleiner ist nahe bei den restlichen Abschnitten der Schwanzteile (5a, 5b).

7. Verbinder nach Anspruch 4, bei dem die dazwischen angeordneten Teile (7a, 7b) der ersten und zweiten Anschlussreihen sich linear entlang ihrer Länge verjüngen.

8. Verbinder nach Anspruch 5, bei dem die dazwischen angeordneten Teile (7a, 7b) der ersten und zweiten Anschlussreihen sich bogenförmig entlang ihrer Länge erweitern.

9. Verbinder nach Anspruch 8, bei dem die bogenförmige Erweiterung konkav ist.

10. Verbinder nach Anspruch 8, bei dem die bogenförmige Erweiterung konvex ist.

11. Verbinder nach einem der vorangehenden Ansprüche, bei dem jeder der Anschlusslötschwanzteile (9a, 9b) einen Montagefuß einschließt und alle Montagefüße der Anschlusslötschwanzteile ungefähr bündig mit der Bodenfläche des Verbindergehäuses (2) angeordnet sind.

12. Verbinder nach einem vorangehenden Anspruch, bei dem die Anschlüsse in der oberen Anschlussreihe in Bezug auf die Anschlüsse in der unteren Reihe versetzt sind.

13. Verbinder nach Anspruch 1, bei dem jeder der dazwischen angeordneten Anschlussteile (7a, 7b) eine vorbestimmte Länge hat, die sich zwischen der Verbindergehäusemontagefläche (2b) und den restlichen Abschnitten der damit verknüpften Anschlussschwanzteile (5a, 5b) erstreckt, wobei jeder der dazwischen liegenden Anschlussteile (7a, 7b) eine Breite hat, die sich entlang seiner Länge verändert, wobei die Breite der dazwischen angeorneten Teile (7a, 7b) ungefähr dieselbe ist wie die Breite der restlichen Abschnitte der Schwanzteile (5a, 5b) und mit der Nähe zu den dazwischen angeordneten Teilen (7a, 7b) zur Verbindermontagefläche (2b) anwächst.

14. Verbinder nach Anspruch 13, bei dem die ersten und zweiten Reihen von Anschlüssen aus der Verbindergehäusemontagefläche (2b) in oberen und unteren Anschlussreihen heraustreten und Anschlüsse in der oberen Reihe in Bezug auf Anschlüsse in der unteren Reihe versetzt sind.

15. Verbinder nach einem vorangehenden Anspruch, bei dem jeder der Anschlussschwanzteile (5a, 5b) einen vertikalen Armteil einschließt, der mit dem damit verknüpften dazwischen angeordneten Teil (7a, 7b) verbunden ist.
